Europäisches Patentamt

European Patent Office

Office européen des brevets

(11) Numéro de publication: **0 398 822**
**A1**

(12) **DEMANDE DE BREVET EUROPEEN**

(21) Numéro de dépôt: **90420221.5**

(22) Date de dépôt: **10.05.90**

(51) Int. Cl.5: **H01L 27/148, H01L 29/796**

(30) Priorité: **16.05.89 FR 8906620**

(43) Date de publication de la demande:
**22.11.90 Bulletin 90/47**

(84) Etats contractants désignés:
**DE GB IT**

(71) Demandeur: **SOCIETE FRANCAISE DE DETECTEURS, INFRAROUGES- SOFRADIR 43-47 rue Camille Pelletan**

**F-92290 Chatenay Malabry(FR)**

(72) Inventeur: **Chatard, Jean Pierre**
**37 rue des glaieuls**
**F-91330 Yerres(FR)**

(74) Mandataire: **Laurent, Michel et al**
**Cabinet Laurent et Charras 20, rue Louis Chirpaz B.P. 32**
**F-69131 Ecully Cédex(FR)**

(54) **Procédé pour homogénéiser les signaux électriques générés par un système de détection et transmis à un système d'exploitation.**

(57) Procédé pour homogénéiser les réponses sous forme de signaux électriques, générés par un système de détection couplé à un système d'exploitation à multiplexage muni d'une pluralité de ligne, dont l'étage d'entrée est muni d'électrodes de stockage, et qui sont définis au moins par leur fonction de partition, ledit système d'exploitation étant destiné à permettre un traitement décalé dans le temps desdites réponses, caractérisé en ce que l'homogénéisation des réponses est effectué au niveau de l'étage d'entrée de chacune desdites lignes du système d'exploitation, par adaptation de leur fonction de partition et/ou de leur poucentage d'ébasage, obtenue par modification de la surface des électrodes de stockage de leur étage d'entrée.

Application : détecteurs à infra-rouges

FIG.4

Xerox Copy Centre

## PROCEDE POUR HOMOGENEISER LES SIGNAUX ELECTRIQUES GENERES PAR UN SYSTEME DE DETECTION ET TRANSMIS A UN SYSTEME D'EXPLOITATION.

La présente invention concerne un procédé destiné à permettre l'homogénéisation de signaux électriques générés par un système de détection et transmis à un dispositif d'exploitation du type multiplexeur, par exemple un dispositif à transfert de charges (DTC). Elle s'applique plus spécifiquement au traitement de signaux générés par un ensemble de photodétecteurs, tels que des photodiodes, dont les photosites ont un angle solide de vue différent d'un site à l'autre. De manière encore plus spécifique, cette invention s'applique aux détecteurs infra-rouge, qui munis de leurs circuits de lecture, sont assemblés dans une enceinte cryogénique.

Par dispositif d'exploitation ou de lecture, ou circuit de lecture, on entend de manière connue un circuit permettant la lecture et le traitement décalé dans le temps (multiplexage) des différents signaux transitant par ce circuit.

De manière connue, on augmente les performances électro-optiques des photodétecteurs et notamment des photodétecteurs à infra-rouge, en en limitant l'angle solide utile également dénommé angle de vue. Cette limitation est le plus souvent réalisée au moyen de diaphragmes d'ouverture adaptée à la structure spatiale de l'ensemble formé par lesdits détecteurs. Il est également possible d'utiliser un système optique, dit "à report de pupille", mais ce type de dispositif s'avère d'utilisation complexe et de coût relativement élevé.

L'utilisation de tels systèmes de détection munis d'un diaphragme, en particulier pour les ensembles de grandes dimensions, qu'il s'agisse de barrettes linéaires ou de matrices, entraîne une vision de l'ouverture du diaphragme par les photosites selon un angle de vue différent d'un photosite à l'autre, ce dernier diminuant avec l'éloignement du photosite par rapport à l'axe optique du système. L'angle solide de vue de chacun des photosites peut se décomposer en deux angles solides distincts, l'un dit angle de vue utile ou angle de vue "signal" enveloppant le système optique précédant le diaphragme, l'autre dit angle solide de vue "parasite" contenant le rayonnement limité par le diaphragme, ne passant pas par le système optique et réfléchi par les parties chaude et froide de l'enceinte du cryostat, du diaphragme ou des détecteurs, ou émis par les parties chaudes du cryostat.

De la sorte, pour un fond homogène observé, le flux de photons atteignant chaque détecteur est fluctuant et varie avec la position de ce dernier, car ce flux est proportionnel à l'angle solide de vue. Cette inhomogénéité affecte soit l'angle solide de vue signal et l'angle de vue parasite, soit plus particulièrement l'angle solide de vue parasite dans le cas de systèmes optiques spéciaux. De fait, la réponse continue du système en est rendue inhomogène, et en pénalise le fonctionnement.

On a proposé dans la demande de brevet français FR-A-2 613 831, de limiter voire d'annuler cette source d'inhomogénéité en faisant varier la surface des photosites, de telle sorte que le produit de l'angle solide de vue par l'aire de chacun des photodétecteurs soit constant, traduisant ainsi la constance du flux de photons pour l'ensemble des photosites au niveau de la détection. Toutefois, des photodétecteurs de surface différente ont des propriétés électriques différentes, notamment lorsqu'il s'agit de photodiodes. De fait, l'inhomogénéité est levée au niveau de la détection. En revanche, les caractéristiques électriques et spatiales ne sont pas constantes d'un photodétecteur à l'autre. De la sorte, si certes le problème de l'homogénéité est résolu au niveau de la détection, ce problème est transféré au niveau de l'exploitation. On n'a fait que déplacer le problème. Par exemple, dans le cas de photodiodes, la résistance dynamique inverse, le courant de court-circuit, le courant de saturation, et la résistance à l'origine de chacune des diodes varient en fonction de la surface de cette dernière avec pour conséquence un fonctionnement inhomogène du circuit de lecture. L'exploitation d'une telle structure devient alors très complexe.

Il est classique d'améliorer les performances d'un dispositif d'imagerie, et en particulier dans le cas de forts flux de photons venant du fond comparés au flux de photons utiles à détecter, d'introduire au niveau du circuit d'exploitation soit une partition des quantités de charges créées, soit un ébasage de celles-ci, afin de n'exploiter qu'un nombre plus réduit de charges, dans le but d'éliminer, ou d'amoindrir le bruit de fond. Ce type de dispositif est par exemple décrit dans les documents EP-A-0 148 086 et EP-A-0 251 386. Toutefois, ce type de dispositif reste d'un usage limité, compte tenu que les traitements effectués le sont indépendemment des dispersions du flux de photons. En effet, dans le deuxième cas par exemple, sa mise en oeuvre suppose l'usage d'un générateur de charges de référence, apte à simuler un fond homogène. Il n'y a donc pas correlation entre flux de photons incidents et partition et/ou ébasage.

On a également décrit dans la publication de CHOW et al dans IEEE TRANSACTIONS ON ELECTRON DEVICES (vol. Ed-29, n° 1, de Janvier 1982, pages 3-13), un étage d'entrée classique d'un DTC muni d'une fonction ébasage et d'une fonction partition, ainsi qu'un étage d'entrée avec amplificateur de contre-réaction, destiné à compenser les diodes de détection présentant une résistance inverse faible. De nouveau, le signal délivré et analysé ne tient pas compte du flux de photons incidents, et ne peut donc valablement moduler ce signal en fonction du positionnement du circuit de détection.

La présente invention vise à pallier ces différents inconvénients. Elle propose un procédé destiné à s'affranchir des inhomogénéités inhérentes tant aux variations de l'angle solide de vue qu'à celles de flux de photons incidents, et plus généralement des inhomogénéités de réponse continue d'un système de détection, et ce non pas en intervenant au niveau de la partie détection du dispositif, mais au niveau du circuit de lecture proprement dit, situé en aval de la dite partie de détection.

La présente invention concerne un procédé pour homogénéiser les réponses, sous forme de signaux continus, générés par un système de détection et transmis à un système d'exploitation, par exemple du type DTC, comportant une pluralité de lignes, dont l'étage d entrée de chaque ligne est muni d'électrodes de stockage et qui sont définis au moins par leur fonction de partition, ledit système d'exploitation étant destiné à permettre un traitement décalé dans le temps (multiplexage) desdites réponses.

Ce procédé est caractérisé en ce que l'homogénéisation des réponses est effectuée au niveau de l'étage d'entrée de chacune desdites lignes du dispositif d'exploitation par adaptation de leur fonction de partition et/ou de leur pourcentage d'ébasage, obtenue par modification de la surface des électrodes de stockage de leur étage d'entrée.

En d'autres termes, la présente invention consiste à faire varier la surface des électrodes de stockage de l'étage d'entrée de chaque ligne du circuit de lecture, en fonction des inhomogénéités de réponse générées par un système de détection couplé au dit circuit de lecture.

Il est connu, particulièrement pour les dispositifs de détection infra-rouge, de n'exploiter qu'une partie des charges générées par le photo-détecteur. Cette élimination de charges étant effectuée au niveau de l'étage d'entrée du circuit de lecture à l'aide d'électrodes métalliques qui portées à des potentiels adéquats, permettent la création de barrières de potentiel séparant les charges stockées en une partie utile exploitée par le circuit de lecture et une partie excédentaire inutile.

La manière dont l'invention peut être réalisée et les avantages qui en découlent, ressortiront mieux des exemples de réalisation qui suivent, donnés à titre indicatif et non limitatif à l'appui des figures annexées.

Les Figures 1 et 2 représentent le fonctionnement schématique d'un circuit à transfert de charges.

La Figure 3 est une représentation schématique de l'étage d'entrée d'un circuit à transfert de charges.

La Figure 4 est une représentation schématique de la surface de l'étage d'entrée d'un DTC.

La Figure 5 est une représentation schématique d'une forme d'application de l'invention.

La Figure 6 est une représentation schématique d'une autre forme d'application de l'invention .

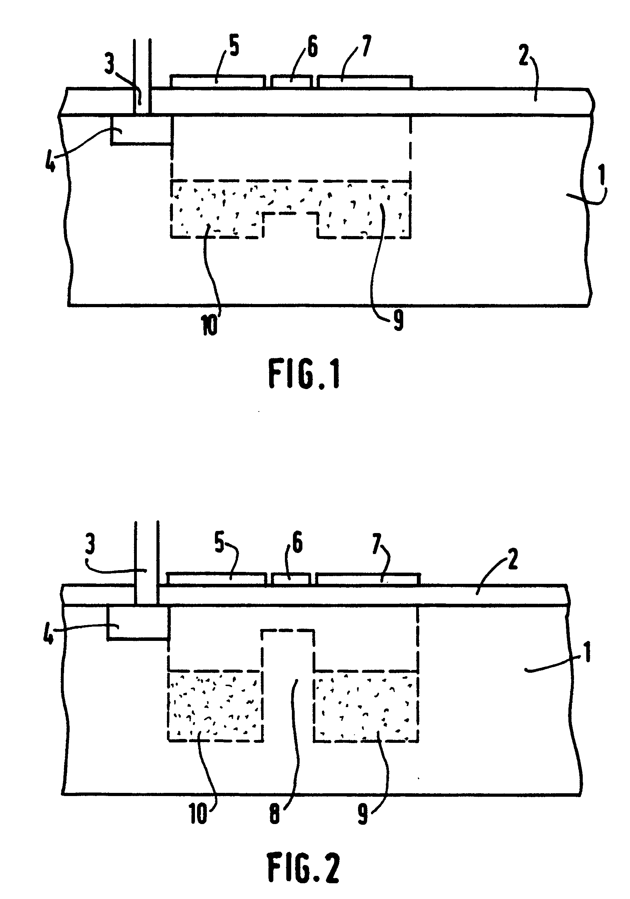

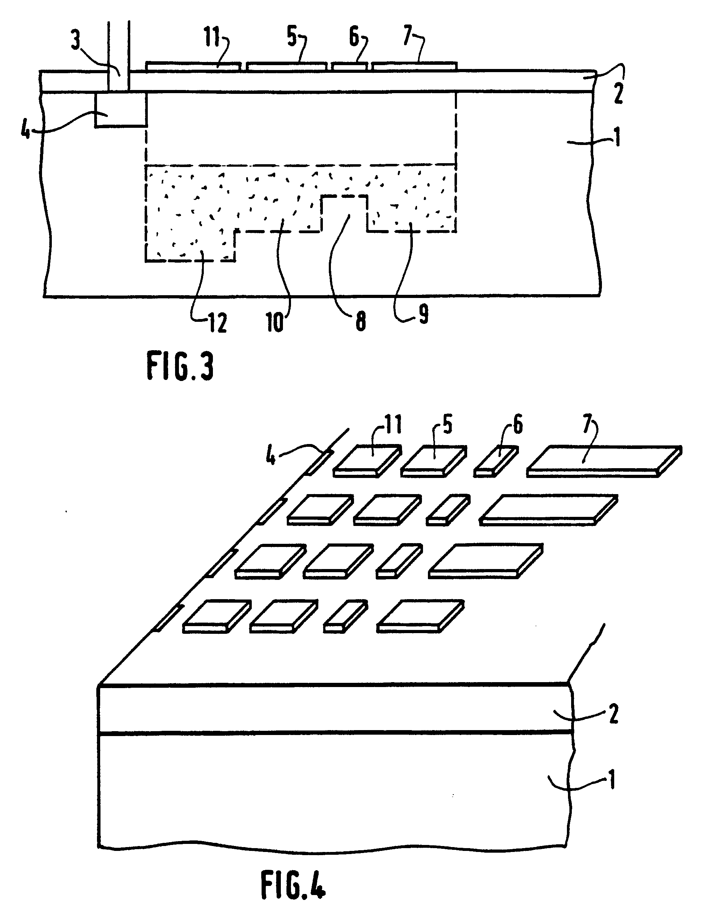

· Comme on peut le voir sur les figures 1 et 2, représentant par exemple le fonctionnement d'un circuit du type dispositif à transfert de charges, on a représenté sous la référence générale (1) un substrat réalisé en silicium, sur lequel repose une couche portant la référence (2), réalisée en silice $SiO_2$ et qui constitue un isolant électrique. Le signal électrique issu du photo-détecteur, en l'occurrence d'une photodiode, est acheminé par la connexion (3) au niveau de la zone référencée (4) qui constitue la zone d'injection de charges. Les charges ainsi injectées sont stockées sous des électrodes (également dénommés grilles) (5 et 7) dites électrodes de stockage. L'électrode référencé (6) est dite "électrode de partition".

Dans l'état initial dit "phase de stockage", les trois électrodes (5,6,7) sont portées à des potentiels tels que les charges se répartissent uniformément (voir figure 1). On a matérialisé par des pointillés la répartition du potentiel électrique dans le matériau. Ces charges remplissent ainsi un puits de potentiel.

On a représenté sur la figure 2 la phase dite "de partition". Au cours de cette phase, l'électrode (6) dite de partition est portée à un potentiel proche de zéro volt, créant de fait une barrière de potentiel référencée (8), et séparant les charges stockées en deux quantités, respectivement l'une utile (9) et l'autre inutile (10). Seule la quantité de charges utiles (9) est exploitée ultérieurement par le circuit de lecture. Elle est stockée provisoirement sous l'électrode de stockage (7).

Les proportions relatives de ces deux quantités de charges ainsi séparées s'expriment par la quantité dénommée coefficient de partition défini comme étant le rapport des surfaces $S_7/(S_5 + S_7)$, $S_5$ et $S_7$ représentant les aires respectives des électrodes de stockage (5) et (7).

Ainsi, l'objet de la présente invention consiste à adapter le coefficient de partition de l'étage d'entrée d'un dispositif d'exploitation faisant office de circuit de lecture en vue du traitement ultérieur de signaux émis par un système de détection, afin de corriger les inhomogénéités de flux des photons incidents, notamment en fonction de la position du photodétecteur sur la barrette ou la matrice de photodiodes.

Dans une forme avantageuse de la présente invention, l'homogénéisation des réponses est complétée de manière concomitante par adaptation du pourcentage d'ébasage de l'étage d'entrée du dispositif de lecture, par exemple un DTC, cette adaptation étant également obtenue par modification de la surface des électrodes de stockage de l'étage d'entrée audit dispositif de lecture.

La figure 3 est une représentation schématique de l'étage d'entrée du circuit de lecture constitué par exemple par un dispositif à transfert de charges, sur laquelle apparait la fonction d'ébasage. Comme dans le cas précédent, le substrat de silicium (1) est recouvert d'une couche (2) en silice $SiO_2$, différentes électrodes étant positionnées sur cette couche (2), notamment une électrode supplémentaire (11) ou grille portée à un potentiel fixe, tel qu'elle génère un puits de potentiel (12) plus profond que les puits de potentiel générés par les électrodes (5) et (7). De la sorte, la quantité de charges supplémentaire, dite ébasée, ne fait pas l'objet de partition ou de transfert lorsque l,électrode (6) est soumise à un potentiel proche de zéro volt. De fait, la surface de stockage évoquée lors de la partition est dans ce cas constituée de la somme $S_{11} + S_5 + S_7$ correspondant à la somme des aires respectives des électrodes (11), (5) et (7). Ainsi, l'invention consiste à faire varier la surface des électrodes de stockage dont celle de l'électrode d'ébasage, afin de modifier de façon souhaitée et adaptée le rapport $S_7/(S_5 + S_7 + S_{11})$ d'une part, et le pourcentage d ébasage défini par $S_{11}$ d'autre part.

En effet, plus grande est l'aire de l'électrode d'ébasage (11) et plus importante est la fonction d'ébasage par rapport au puits potentiel défini par les électrodes (5) et (7). De la sorte on peut éliminer un bruit de fond important généré par le fond de photons.

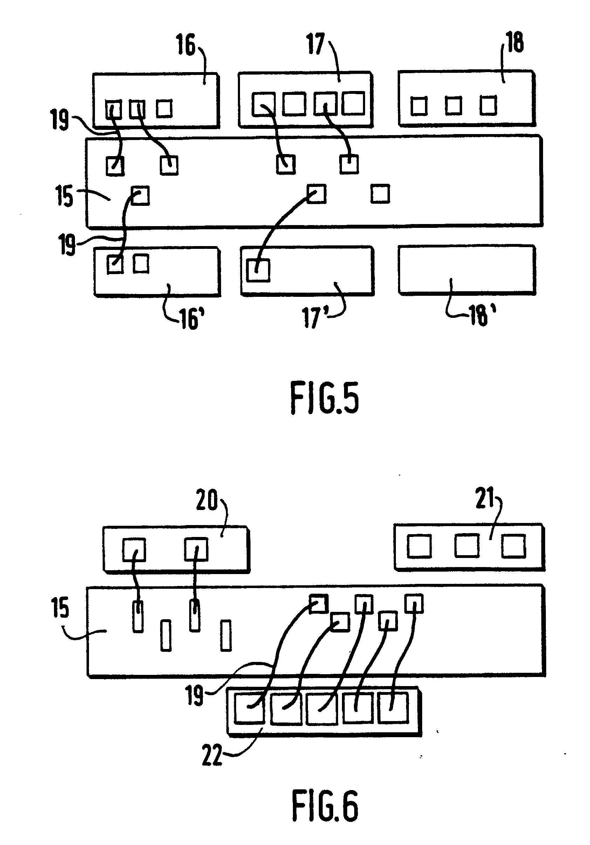

La figure 4 est une représentation schématique de la surface de l'étage d'entrée d'un DTC. Les électrodes de surface variable sont obtenues de façon connue lors de l'étape de fabrication du circuit de lecture, le masque de photo-litographie servant à l'étape de création des électrodes présentant des surfaces appropriées correspondant aux électrodes (5,7 et 11).

On peut adapter de façon simple la détermination de la variation des surfaces à la loi de variation de l'angle solide de vue, cette dernière variant d'un type de dispositif à l'autre.

De la sorte, pour un dispositif constitué de photo-détecteurs de surface constante S, chacun d'entre eux reçoit un flux de photons sous des angles solides de vue variable et connu $\theta_1,...\theta_i,...\theta_n$, le flux de photons reçu par chacun des détecteurs est proportionnel à $\theta_1.S,....\theta_i.S,...\theta_n.S$ .

Chacun des photo-détecteurs injecte alors dans l'étage d'entrée de la ligne du circuit d'exploitation qui lui est affectée une quantité de charges Q telle que:
$$Q_1 = A.\theta_1.S, \quad Q_i = A.\theta_i.S, \quad Q_n = A.\theta_n.S$$
expressions dans lesquelles A représente une constante.

Ces quantités de charges sont séparées par partition, les quantités de charges utiles transférables étant définies par la relation :

$$q_i = Q_i \frac{s^i_7}{s^i_5 + s^i_7} = A.S.\theta_1 \frac{s^i_7}{s^i_5 + s^i_7}$$

ces quantités étant toutes rendues identiques, les surfaces $s^i_5$ et $s^i_7$ des électrodes de stockage (5) et (7) étant telles que le produit

$$\theta_i \cdot \frac{s^i_5}{s^i_5 + s^i_7}$$

soit constant.

Il est à noter que la mise en oeuvre de l'invention tant pour l'exploitation de la fonction ébasage seule , ou en conjonction avec la fonction de partition de l'étage d'entrée du circuit de lecture répond à la même démarche. Dans la pratique, en raison des spécificités de chaque dispositif et de la complexité des phénomènes observés et détectés (barette linéaire ou matrice, taille du circuit de détection, longueur d'onde de fonctionnement, fréquence de lecture, ...), une partie seulement de la loi de variations des surfaces des électrodes peut être évaluée a priori, l'optimum de cette loi de variation n étant déterminé que par l'expérience issue, par exemple, d une première réalisation approchée.

De manière avantageuse, on fixe la surface de l'une des électrodes pour tout le circuit, par exemple celle de l'électrode (5), et on ne fait varier que celle de l'électrode (7) .

Comme déjà dit, les circuits de grandes dimensions sont particulièrement affectés par les gradients de réponse continue, la différence d'angle de vue entre un photosite central et un photosite d'extrémité s'accroissant avec leur éloignement. En outre, certains circuits ont des dimensions telles qu'il n'est plus possible de les réaliser de façon monolithique, soit compte tenu de la non disponibilité de matériau de dimensions suffisantes, soit des trop grandes difficultés à traiter à tous les niveaux des puces de détection ou de lecture de très grandes dimensions, notamment en ce qui concerne leur manipulation, leur interconnexion, ainsi que les difficultés liées au montage, et enfin du fait du rendement de fabrication réduit inhérent aux grandes géométries.

Dans une application de l'invention, telle que représentée dans les figures 5 et 6, les circuits de détection et/ou de lecture sont constitués de puces élémentaires de taille réduite, juxtaposées, dont on adapte le nombre en fonction du circuit final à réaliser. De fait, ces puces élémentaires peuvent être mises en place bout-à-bout (figure 5), ou en quinconce (figure 6), leur interconnexion avec le circuit de lecture pouvant être réalisée par toute méthode connue, telles que par exemple soudures par fils, ou hybridation collective par micro-billes métalliques.

Il s'avère alors économique dans certains cas d'effectuer les corrections de niveau continu, selon le procédé conforme à l'invention, en utilisant des puces élémentaires de circuit de lecture, dont les fonctions d'ébasage et/ou de partition sont constantes sur chacune des puces considérées, mais diffèrent d'une puce à l'autre.

Ainsi, dans les figures 5 et 6, on a représenté un circuit de détection (15) monolithique, constitué d'une barette linéaire pouvant compter plus de mille photosites, et de longueur typiquement voisine de vingt millimètres.

On a représenté, associées avec ce circuit de détection (15), six puces (16,16',17,17',18,18') de circuit de lecture, identiques deux à deux, cette dernière caractéristique n'étant nullement impérative. Ces puces (16-18') sont réparties de part et d'autre du circuit de détection (15), et sont interconnectées avec ce dernier au moyen de fils conducteurs (19).

Le procédé conforme à l'invention est alors mis en oeuvre en faisant varier les capacités de stockage des étages d'entrée des puces centrales (17,17'), par rapport aux puces latérales (16,16',18,18'), induisant de la sorte une adaptation des fonction de partition et d'ébasage à la partie du circuit de détection qu'elles gèrent.

On a représenté au sein de la figure 6, une forme de réalisation voisine de celle précédemment décrite, et dans laquelle les puces (20,21,22) sont positionnées en quinconce les une par rapport aux autres.

Ainsi, si certes la mise en oeuvre de l'invention n'est pas d'une efficacité absolue pour la correction de photosite à photosite, en revanche, elle présente l'avantage économique d'utiliser des puces de lecture de conception plus simple, et d'accéder également plus économiquement à un optimum , en effectuant des essais successifs de puces aux fonctions ébasage et partition différentes, du fait de leur interchangeabilité.

Le procédé et le dispositif ainsi réalisés permettent l'obtention de caractéristiques électro-optiques de détecteur non fluctuentes et homogènes, directement exploitables par un système de traitement associé au circuit de lecture. Ils sont donc particulièrement adaptés aux traitements de signaux générés par tout système détecteur couplé à un circuit de lecture du type multiplexeur.

## Revendications

1/ Procédé pour homogénéiser les réponses sous forme de signaux électriques générés par un système de détection et transféré à un système d'exploitation à multiplexage, comportant une pluralité de lignes, dont l'étage d'entrée de chaque ligne est muni d'électrodes de stockage, et qui sont définies au moins par leur fonction de partition, ledit système d'exploitation étant destiné à permettre un traitement décalé dans le temps desdites réponses, caractérisé en ce que l'homogénéisation des réponses est effectué au niveau de l'étage d'entrée de chacune desdites lignes du système d exploitation, par adaptation de leur fonction de partition et/ou de leur pourcentage d'ébasage, obtenue par modification de la surface des électrodes de stockage de leur étage d'entrée.

2/ Procédé pour homogénéiser les réponses d'un ensemble de photo-détecteurs dont les photosites ont un angle solide variable d'un site à l'autre, couplés à un circuit de lecture et de traitement comportant une pluralité de lignes dont chaque étage d'entrée est muni d'électrodes de stockage, et définies au moins par leur fonction de partition, caractérisé en ce que l'homogénéisation est effectuée au niveau de l'étage d'entrée desdites lignes du circuit de lecture et de traitement par adaptation de leur fonction de partition et de leur pourcentage d'ébasage obtenu par modification de la surface des électrodes de stockage de leur étage d'entrée.

3/ Système d'exploitation pour homogénéiser les réponses sous forme de signaux générés par un système de détection couplé à un circuit de lecture et de traitement constitutif dudit système d'exploitation, comportant un dispositif de lecture, muni d'une pluralité de lignes, caractérisé en ce que la surface des éléctrodes (5,7,11) de l'étage d'entrée de chacune desdites lignes du dispositif de lecture varie d'une ligne à l'autre afin d'adapter la fonction de partition et/ou le pourcentage d ébasage desdites lignes du dispositif de lecture, pour homogénéiser l'ensemble des signaux issus des lignes du circuit de lecture et de traitement en vue d'une exploitation ultérieure.

4/ Système d'exploitation selon la revendication 3, caractérisé en ce que le dispositif de lecture est un dispositif à transfert de charges.

FIG.1

FIG.2

FIG.3

FIG.4

FIG.5

FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | EP-A-0 251 386 (LABORATOIRES D'ELECTRONIQUE ET DE PHYSIQUE APPLIQUEE L.E.P.)<br>* Revendications; figures * | 1-4 | H 01 L 27/148<br>H 01 L 29/796 |
| A,D | EP-A-0 148 086 (THOMSON-CSF)<br>* En entier * | 1,2,4 | |
| A | US-A-4 684 800 (A.L. MORSE et al.)<br>* En entier * | 1,2,4 | |
| A,D | IEEE TRANSACTIONS ON ELECTRON DEVICES, vol. ED-29, no. 1, January 1982, pages 3-13, IEEE, New York, US; K. CHOW et al.: "Hybrid infrared focal-plane arrays"<br>* Pages 3,4; page 5, colonne 1 * | 1-4 | |
| | | | **DOMAINES TECHNIQUES RECHERCHES (Int. Cl.5)**<br><br>H 01 L |

Le présent rapport a été établi pour toutes les revendications

| Lieu de la recherche | Date d'achèvement de la recherche | Examinateur |
|---|---|---|
| LA HAYE | 07-08-1990 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
......................................................................
& : membre de la même famille, document correspondant

EPO FORM 1503 03.82 (P0402)